# DEMANDE DE BREVET EUROPEEN

(11) **EP 3 007 353 A1**
(43) Date de publication de la demande: **13.04.2016**
(21) Numéro de dépôt: 15189099.3
(22) Date de dépôt: 09.10.2015
(51) Int. Cl.: H03F 1/02, H03F 3/195, H03F 3/24, H03F 3/60, H03F 3/72, H03F 3/21

(54) **DISPOSITIF D'AMPLIFICATION DE PUISSANCE RECONFIGURABLE ET CIRCUIT INTÉGRÉ COMPORTANT UN TEL DISPOSITIF**

(30) Priorité: 09.10.2014 FR 1402274
(71) Demandeur: THALES, 92400 Courbevoie (FR); Université de Bordeaux, 33000 Bordeaux (FR); Institut Polytechnique de Bordeaux, 33402 Talence Cedex (FR); Centre National de la Recherche Scientifique (C.N.R.S.), 75016 Paris (FR)
(72) Inventeur: MALLET-GUY, Benoit, 33600 PESSAC (FR); DUPUY, Victor, 78180 Montigny Le Bretonneux (FR); PLAZE, Jean-Philippe, Antoine, 78851 ELANCOURT (FR); AURIC, Claude, Jean, 78851 ELANCOURT (FR); MANUSCO, Yves, 78851 ELANCOURT (FR); KERHERVE, Eric, 33600 PESSAC (FR); DELTIMPLE, Nathalie, 33600 PESSAC (FR)
(74) Mandataire: Blot, Philippe Robert Emile

(57) **Abrégé**

Ce dispositif d'amplification de puissance reconfigurable (110) comporte, entre une entrée (112) et une sortie (114), une première voie de puissance (115) et une seconde voie de puissance (117), et un moyen de commutation pour sélectionner dynamiquement l'une ou de l'autre des voies de puissance pour faire cheminer une puissance entre l'entrée et la sortie du dispositif.

Le moyen de commutation comporte un coupleur de sortie (132) propre à fonctionner dans un mode coupleur ou dans un mode combineur, et un circuit de pilotage (136, 138) du coupleur de manière à le faire fonctionner soit en mode coupleur, pour que le chemin de puissance passe par la seconde voie de puissance, soit en mode combineur pour que le chemin de puissance passe par la première voie de puissance.

Application à un circuit intégré en technologie hybride ou MMIC.

## Description

L'invention a pour domaine celui des dispositifs d'amplification de puissance et, plus particulièrement, des dispositifs d'amplification de puissance reconfigurables.

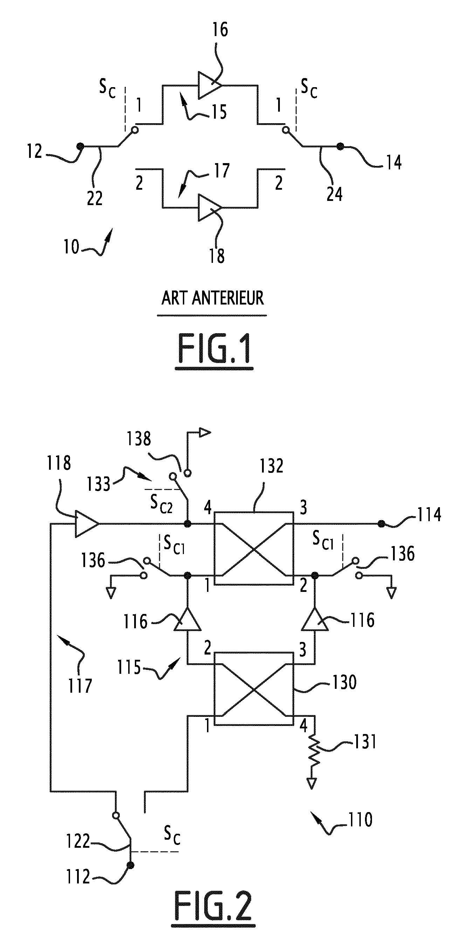

Un dispositif d'amplification de puissance reconfigurable de l'état de la technique est représenté sur la figure 1.

Le dispositif 10 est un composant de type « dipôle », comportant une entrée 12 et une sortie 14.

Entre l'entrée 12 et la sortie 14, le dispositif 10 comporte des première et seconde voies de puissance, 15 et 17, caractérisées par des propriétés d'amplification différentes. Par exemple, la première voie 15 comporte un premier amplificateur 16 et la seconde voie 17 comporte un second amplificateur 18, les premier et second amplificateurs ayant des coefficients d'amplification différents. Plus généralement, les première et seconde voies de puissance peuvent présenter des propriétés différentes en termes de puissance délivrée, mais aussi en termes de fréquence de travail.

Pour faire cheminer la puissance le long de la première voie 15 ou de la seconde voie 17, le dispositif 10 comporte des moyens de commutation. Les moyens de commutation comportent un commutateur d'entrée 22 et un commutateur de sortie 24.

Dans une première position du commutateur d'entrée 22, respectivement du commutateur de sortie 24, l'entrée 12, respectivement la sortie 14, du dispositif 10 est connectée à l'entrée, respectivement à la sortie, du premier amplificateur 16. Dans une seconde position du commutateur d'entrée 22, respectivement du commutateur de sortie 24, l'entrée 12, respectivement la sortie 14, du dispositif 10 est connectée à la borne d'entrée, respectivement de sortie, du second amplificateur 18.

La position de chaque commutateur 22, 24, est commandée en fonction du niveau d'un signal de commande Sc appliqué à une borne de commande du commutateur. Les signaux de commande sont synchronisés pour que les commutateurs d'entrée 22 et de sortie 24 soient simultanément dans leur première position ou dans leur seconde position.

Ainsi, dans la première position des commutateurs d'entrée 22 et de sortie 24, la puissance appliquée sur l'entrée 12 chemine le long de la première voie 15 de manière à être amplifiée par le premier amplificateur 16. Sur la sortie 14 du dispositif 10 est délivrée une puissance amplifiée. La première voie 15 est donc passante, alors que la seconde voie 17 est en circuit ouvert.

En revanche, lorsque les deux commutateurs d'entrée 22 et de sortie 24 sont dans leur seconde position, la puissance appliquée sur l'entrée 12 chemine le long de la seconde voie 17 de manière à être amplifiée par le second amplificateur 18. La puissance ainsi générée est délivrée sur la sortie 14 du dispositif 10. La première voie 15 est alors en circuit ouvert, alors que la seconde voie 17 est passante.

Par exemple, si les amplificateurs 16 et 18 ont des propriétés différentes en bande de fréquence de travail, un signal de commande Sc adapté est appliqué aux commutateurs d'entrée 22 et de sortie 24 pour qu'ils basculent de leur première position vers leur seconde position, pour que le chemin de puissance corresponde à la seconde voie de puissance, afin d'augmenter le niveau de la puissance délivrée par le dispositif 10 dans la bande de fréquence de travail souhaitée. Le dispositif 10 est ainsi reconfigurable en fonction de la bande de fréquence de travail du signal à amplifier.

L'architecture de ce dispositif permet d'avoir un composant de type dipôle comportant une seule entrée globale et une seule sortie globale et pouvant fonctionner sous deux configurations alternatives, dès que les première et seconde voies présentent des propriétés différentes.

Cependant, un tel dispositif présente deux inconvénients majeurs et irréductibles, car liés à l'architecture du dispositif.

Le premier problème réside dans le fait qu'un commutateur, d'entrée ou de sortie, possède une limite de tenue en puissance. Au-delà d'une puissance seuil, un commutateur change d'état de fonctionnement, ce qui a pour conséquence une augmentation des pertes à la traversée de ce commutateur. Dans l'architecture présentée ci-dessus, c'est le commutateur de sortie, exposé à de plus fortes puissances, qui risque d'atteindre sa limite de tenue en puissance en premier. A cause de ces pertes, le rendement global du dispositif est réduit.

De manière concomitante à un changement d'état de fonctionnement d'un commutateur, se produit une réduction de l'isolement électrique de la voie en circuit ouvert. Dans un cas extrême, le commutateur est endommagé et ne peut plus remplir sa fonction d'aiguillage de la puissance vers ou depuis l'un ou l'autre des voies de puissance.

Le second problème affectant les dispositifs d'amplification de puissance reconfigurables connus réside dans le fait que les commutateurs génèrent des pertes lors du passage de courant. Ainsi, la puissance délivrée sur la borne de sortie par le premier ou le second amplificateur ne se retrouve pas intégralement sur la sortie 14 du dispositif 10. De manière similaire, la puissance appliquée sur l'entrée 12 ne se retrouve pas intégralement sur la borne d'entrée du premier ou du second amplificateur. Une partie de la puissance est perdue à la traversée du commutateur, en particulier à la traversée du commutateur de sortie. Ce second problème est particulièrement dommageable pour un dispositif d'amplification de puissance reconfigurable à haut rendement. Le rendement global du dispositif sera d'autant plus faible que les pertes générées par chaque commutateur seront importantes.

L'invention a donc pour but de palier aux problèmes précités.

A cet effet, l'invention a pour objet un dispositif un dispositif d'amplification de puissance reconfigurable comportant, entre une entrée et une sortie, une première voie de puissance et une seconde voie de puissance, et un moyen de commutation pour sélectionner dynamiquement l'une ou de l'autre des voies de puissance pour faire cheminer une puissance entre l'entrée et la sortie du dispositif, caractérisé en ce que le moyen de commutation comporte un coupleur de sortie propre à fonctionner sélectivement dans un mode coupleur ou dans un mode combineur, et un circuit de pilotage du coupleur de manière à le faire fonctionner soit en mode coupleur, pour que le chemin de puissance passe par la seconde voie de puissance, soit en mode combineur pour que le chemin de puissance passe par la première voie de puissance.

Le dispositif selon l'invention permet une commutation entre l'une ou l'autre des voies de puissance sans que les moyens de commutation n'engendrent de perte, ou limitent la tenue en puissance.

Suivant d'autres aspects avantageux de l'invention, le dispositif comprend une ou plusieurs des caractéristiques suivantes, prise(s) isolément ou suivant toutes les combinaisons techniquement possibles :
- le coupleur de sortie comporte un port direct d'entrée et un port d'entrée couplée connectés à la première voie de puissance, un port de sortie couplée connecté à la seconde voie de puissance, et un port de sortie directe connecté à la sortie du dispositif ;
- les ports d'entrée directe et couplée du coupleur de sortie sont connectés à la masse via des premiers interrupteurs commandés, et le port de sortie couplée du coupleur de sortie est connecté à la masse, via à un second interrupteur, le mode coupleur étant obtenu en plaçant le second interrupteur dans une position ouverte et en plaçant les premiers interrupteurs dans une position fermée, tandis que le mode combineur est obtenu en plaçant le second interrupteur dans une position fermée et en plaçant les premiers interrupteurs dans une position ouverte ;
- la première voie comporte une paire de premiers amplificateurs en parallèle l'un de l'autre, la borne de sortie d'un amplificateur parmi les premiers amplificateurs étant connectée au port d'entrée directe du coupleur de sortie, la borne de sortie de l'autre amplificateur parmi les premiers amplificateurs étant connectée au port d'entrée couplée du coupleur de sortie ;

- les signaux en sortie de chacun des premiers amplificateurs de la première voie de puissance sont en quadrature l'un de l'autre et, de préférence, possèdent la même amplitude ;
- les signaux appliqués sur la borne d'entrée de chacun des premiers amplificateurs de la première voie de puissance sont délivrés respectivement par un port d'entrée couplée et par un port de sortie directe d'un coupleur d'entrée, dont un port d'entrée directe est connectée à l'entrée du dispositif et dont un port de sortie couplée est connecté à une charge, de manière à fonctionner en mode coupleur ;
- le moyen de commutation comporte, en outre, un commutateur d'entrée qui, dans une première position, connecte l'entrée du dispositif à la première voie de puissance et, dans une seconde position, l'entrée à la seconde voie de puissance, le commutateur d'entrée et les moyens de pilotage du coupleur de sortie étant commandés de manière synchronisée ;
- les propriétés d'amplification des première et seconde voies de puissance sont différentes en termes de gain et/ou de bande passante ;
- la première voie de puissance correspond à un fonctionnement du dispositif en bande passante étroite et forte puissance, tandis que la seconde voie de puissance correspond à un fonctionnement du dispositif en bande passante large et moyenne puissance.

L'invention concerne également un circuit intégré en technologie hybride ou MMIC, comportant un dispositif d'amplification de puissance reconfigurable tel que défini ci-dessus.

L'invention sera mieux comprise à la lecture de la description qui va suivre d'un mode de réalisation particulier, donné uniquement à titre d'exemple illustratif et non limitatif, la description étant faite en se référant aux dessins annexés, sur lesquels :
- la figure 1 est une représentation schématique d'un dispositif d'amplification de puissance reconfigurable conformément à l'art antérieur ;
- la figure 2 est une représentation schématique d'un dispositif d'amplification de puissance reconfigurable selon la présente invention ;
- les figures 3 et 4 sont des représentations schématiques des modes de fonctionnement, respectivement couplé et combiné, d'un coupleur de LANGE intégré dans le dispositif de la figure 2 ;
- les figures 5, 6 et 7 sont des graphes représentatifs du fonctionnement du dispositif de la figure 2.

La figure 2 représente le mode de réalisation actuellement préféré d'un dispositif d'amplification de puissance reconfigurable 110.

Le dispositif 110 est un composant de type dipôle, comportant une entrée 112 globale et une sortie 114 globale.

Le dispositif 110 comporte deux voies de puissance disposées en parallèle l'une de l'autre et totalement indépendantes l'une de l'autre. En variante, le dispositif comporte N voies de puissance, disposées en parallèle les unes des autres et totalement indépendantes les unes des autres. Chaque voie de puissance possède des propriétés d'amplification différentes de l'autre ou de chaque autre voie de puissance.

La première voie de puissance 115 du dispositif 110 comporte un coupleur d'entrée 130 et des moyens d'amplifications comportant deux premiers amplificateurs 116 identiques entre eux et disposés en parallèle l'un de l'autre.

La seconde voie de puissance 117 comporte des moyens d'amplification comportant un second amplificateur 118.

En variante, les moyens d'amplification de chaque voie de puissance sont constitués par l'association de différents composants d'amplification et de prétraitement du courant circulant sur la voie de puissance correspondante. Par exemple, en plus d'un amplificateur de puissance, le moyen d'amplification peut comporter un filtre de manière à sélectionner une fréquence de travail de la voie de puissance correspondante.

Pour la commutation du chemin de puissance entre l'entrée 112 et la sortie 114, le long de la première voie 115 ou de la seconde voie 117, le dispositif 110 comporte des moyens de commutation.

Les moyens de commutation comportent un commutateur d'entrée 122, propre dans une première position à connecter la première voie 115 à l'entrée 112 et dans une seconde position à connecter la seconde voie 117 à l'entrée 112. La position du commutateur d'entrée 122 est commandée par le niveau d'un signal de commande Sc appliqué sur une borne de commande du commutateur d'entrée 122.

Les moyens de commutation comportent en outre un coupleur de sortie 132 et un circuit de pilotage 133 du mode de fonctionnement du coupleur de sortie 132.

Le circuit de pilotage 133 comporte trois interrupteurs, respectivement une paire de premiers interrupteurs 136, et un second interrupteur 138. La position ouverte ou fermée de chaque interrupteur 136, 138 permet de modifier dynamiquement le mode de fonctionnement du coupleur de sortie 132 et de connecter sélectivement la première voie ou la seconde voie, à la sortie 114.

Le coupleur de sortie 132 est propre à fonctionner en mode coupleur ou en mode combineur.

Le coupleur de sortie 132 est de préférence un composant passif à quatre ports comportant conventionnellement un port d'entrée directe 1, un port d'entrée couplée 2, un port de sortie directe 3 et un port de sortie couplée 4.

Avantageusement, le coupleur de sortie 132 est un coupleur en quadrature, propre à fournir, à partir d'un signal d'entrée, deux signaux de sortie en quadrature de phase l'un de l'autre.

Le coupleur de sortie 132 est de préférence un coupleur de Lange.

Un tel composant est classiquement utilisé en mode coupleur équilibré pour remplir la fonction de coupleur comme présenté dans l'article J. Lange "Interdigitated Stripline Quadrature Hybrid (Correspondence)", IEEE Transactions on Microwave Theory and Techniques, vol.17, no.12, pp.1150,1151, Dec 1969.

En mode coupleur équilibré, le port de sortie couplée 4 est connecté à une charge, en particulier une impédance de 50 Ohms, pour permettre un fonctionnement nominal du coupleur. Un signal d'entrée est appliqué sur le port d'entrée directe 1. Des signaux de sortie sont alors récupérés sur le port d'entrée couplée 2 et sur le port de sortie directe 3. Ces deux signaux de sortie ont la même amplitude (celle du signal d'entrée), mais sont déphasés de 90° l'un par rapport à l'autre.

Un tel composant est également classiquement utilisé en mode combineur équilibré pour remplir la fonction de combineur de puissance, comme présenté dans l'article de M. Satoshi et al. "Over 10W C-Ku band GaN MMIC non-uniform distributed power amplifier with broadband couplers", 2010 IEEE MTT-S International Microwave Symposium Digest (MTT), pp.1388, 1391, 23-28 May 2010.

En mode combineur équilibré, une fois encore, le port de sortie couplée 4 est connecté à une charge, en particulier une impédance de 50 Ohms, pour l'équilibrage du coupleur. Les ports d'entrée directe 1 et couplée 2 reçoivent des signaux d'entrée. Le port de sortie directe 3 est celui sur lequel le signal de sortie est récupéré. Ce signal de sortie correspond à la sommation des signaux appliqués en entrée.

La puissance récupérée sur le port de sortie directe 3 sera maximale lorsque les signaux appliqués sur les ports d'entrée directe 1 et couplée 2 sont de même amplitude et en quadrature de phase l'un de l'autre. En effet, le port d'entrée directe 1 est relié directement au port de sortie directe 3, alors que le port d'entrée couplée 2 n'est relié au port de sortie directe 3 que par un couplage électromagnétique qui introduit un déphasage de 90°. La recombinaison en puissance sera donc maximale sur le port de sortie directe 3 si les signaux sur les ports d'entrée 1 et 2 sont en quadrature.

Dans le dispositif 110, le coupleur de sortie 132 est utilisé soit en mode coupleur, soit en mode combineur, afin de réaliser la fonction de commutation du chemin de puissance à travers l'une ou l'autre des voies de puissance.

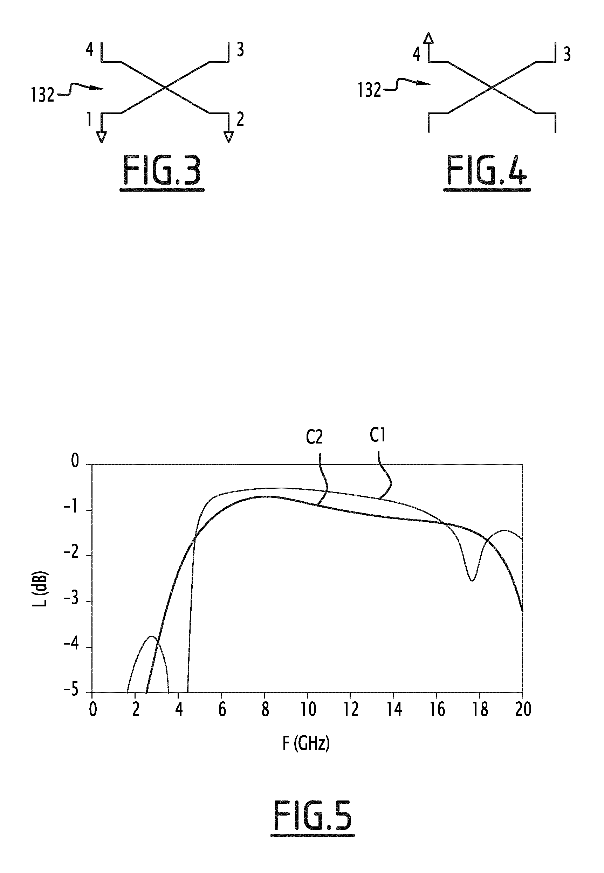

Sur le schéma de la figure 3, le coupleur 132 est dans le mode coupleur : les ports d'entrée directe 1 et couplée 2 sont court-circuités à la masse. Le signal appliqué en entrée du coupleur 132 est appliqué sur le port de sortie couplée 4, qui, dans l'utilisation classique, est connecté à une charge. Le signal de sortie est collecté sur le port de sortie directe 3, qui constitue la sortie du coupleur 132. Dans ce mode de fonctionnement, la connexion des ports 1 et 2 à la masse permet d'assurer un transfert maximal de puissance entre les deux autres ports du coupleur 132.

Sur le schéma de la figure 4, le coupleur 132 est dans le mode combineur : alors que le port de sortie couplée 4 est connecté à la masse, des signaux d'entrée sont appliqués sur les ports d'entrée directe 1 et couplée 2. Ces signaux d'entrée sont en quadrature de phase l'un de l'autre. Un signal de sortie est collecté sur le port de sortie directe 3 du coupleur. Le signal de sortie est égal à la sommation des deux signaux d'entrée. Le coupleur 132 est ici utilisé comme un combineur de puissance classique, à l'exception du fait que le port de sortie couplée 4 et non plus connecté à une charge, mais court-circuité à la masse.

En se référant à nouveau à la figure 2, la borne de sortie d'un premier amplificateur 116 est connectée au port d'entrée directe 1 du coupleur de sortie 132, la borne de sortie de l'autre premier amplificateur 136 est connectée au port d'entrée couplée 2, la borne de sortie du second amplificateur 118 est connectée au port de sortie couplée 4 et la sortie 114 est connectée au port de sortie directe 3.

Chaque premier interrupteur 136 est placé entre un pôle d'entrée 1 ou 2 du coupleur 132 et la masse, en dérivation de la borne de sortie d'un des premiers amplificateurs 116.

Le second interrupteur 138 est placé entre le pôle de sortie couplée 4 du coupleur 132 et la masse, en dérivation de la borne de sortie du second amplificateur 118.

Chaque interrupteur est commandé par un signal de commande Sc1, Sc2, par exemple une tension de commande, pour passer de la position fermée à la position ouverte et inversement. Dans la position ouverte, chaque interrupteur a un comportement de circuit ouvert, alors qu'en position fermée il devient passant et a un comportement de court-circuit à la masse.

Si les premiers interrupteurs 136 sont en position fermée tandis que le second interrupteur 138 est en position ouverte, le coupleur 132 fonctionne en mode couplé, la voie passante étant alors la seconde voie 117. En revanche, si les premier interrupteurs sont en position ouverte et le second interrupteur est en position fermée, le coupleur 132 fonctionne en mode combineur, la voie passante étant alors la première voie 115.

Le coupleur d'entrée 130, qui fonctionne en mode coupleur classique, permet avantageusement de générer des signaux qui soient de même amplitude et en quadrature l'un de l'autre. Pour cela, le coupleur d'entrée 130 a son port d'entrée directe 1 connecté à l'entrée 112 du dispositif, via le commutateur d'entrée 122, son port de sortie couplée 4 connectée à une charge 131, telle qu'une impédance de 50 Ohms, par ailleurs reliée à la masse. Le coupleur d'entrée 130 a son port d'entrée couplée 2 connecté à la borne d'entrée de l'un des deux premiers amplificateurs 116 et son port de sortie directe 3 connecté à la borne d'entrée de l'autre des premiers amplificateurs 116. Ces signaux en quadrature et de même amplitude, une fois amplifiés, sont appliqués en entrée du coupleur de sortie 132, fonctionnant en mode combineur.

Ainsi, en réglant de manière adaptée les signaux de commande des interrupteurs 136 et 138, et du commutateur d'entrée 122, il est possible de sélectionner dynamiquement la voie de puissance passante entre l'entrée 112 et la sortie 114 du dispositif 110, afin de choisir entre les propriétés d'amplification de la première voie de puissance ou celles de la seconde voie de puissance. Le dispositif 110 répond bien au besoin d'un amplificateur de puissance reconfigurable, à savoir qu'il y a deux chemins distincts possibles pour une seule et même entrée et une seule et même sortie, avec un moyen de commutation dynamique entre les deux chemins.

Les figures 5 à 7 résultent de simulations.

La figure 5 représente les pertes générées à travers le coupleur de sortie 132 en mode coupleur (courbe C2) et en mode combineur (courbe C1).

On constate que les pertes sont minimales dans le mode combineur, alors que la bande passante est maximale dans le mode coupleur.

En conséquence et puisque le mode combineur correspond à l'application de la puissance sur deux entrées du coupleur de sortie 132, on privilégiera le mode de fonctionnement combineur pour le voie de puissance le long de laquelle on cherche à maximiser la puissance délivrée en sortie, c'est-à-dire à avoir un rendement très élevé, alors que le mode de fonctionnement coupleur sera dédié à la voie de puissance le long de laquelle on cherche à avoir la bande passante la plus large.

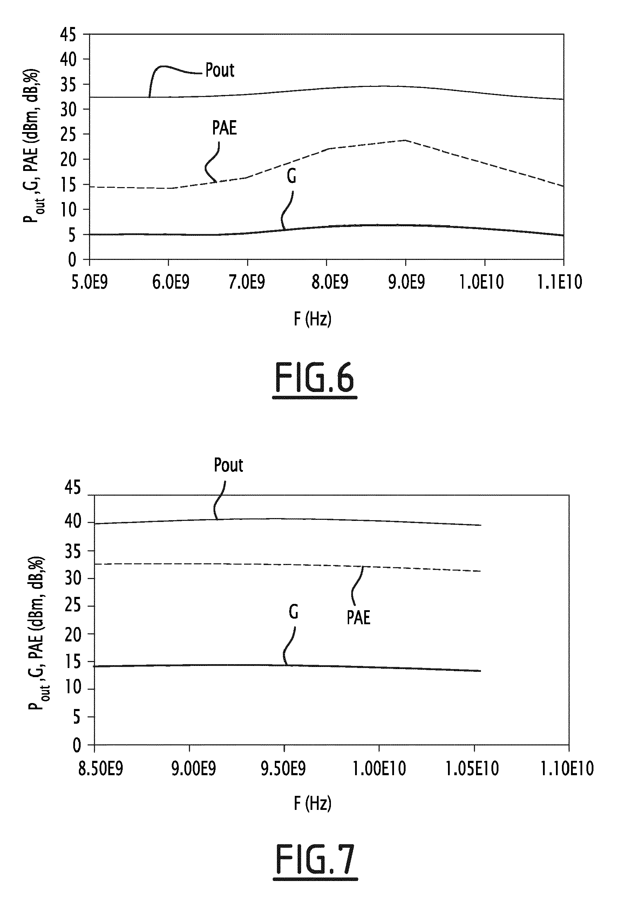

Les figures 6 et 7 représentent le comportement global en puissance du dispositif 110. Sur la figure 6, dans le mode coupleur du coupleur de sortie, c'est-à-dire le long de la seconde voie 117, on relève une puissance de sortie Pout supérieure à 32 dBm, avec un rendement en puissance ajouté PAE supérieur à 14 %, sur une bande en fréquence F entre 5 GHz et 11 GHz.

Sur la figure 7, dans le mode combineur du coupleur de sortie, c'est-à-dire le long de la première voie 115, on relève un gain G élevé, une puissance de sortie Pout supérieure à 40 dBm (10 W), avec un rendement en puissance ajoutée PAE supérieur à 33 %, sur une bande de fréquence F allant de 8 à 10 GHz.

Ainsi, le dispositif selon l'invention met en oeuvre, pour la commutation entre les voies de puissance, un composant passif du type coupleur de Lange et des interrupteurs qui sont positionnés en parallèle du chemin de puissance. La commutation entre les différentes voies de puissance est réalisée en s'affranchissant de la mise en oeuvre de commutateurs placés en série dans le chemin de puissance, tout au moins en sortie, là où la puissance est importante.

Il est en effet à noter que, dans le mode de réalisation de la figure 2, le commutateur d'entrée 112 est intégré en série du chemin de puissance, de manière classique. Cependant, du côté de l'entrée du dispositif d'amplification, il n'y a pas de contraintes fortes en termes de tenue en puissance, ce commutateur étant placé avant les étages d'amplification de puissance. En variante, un coupleur similaire au coupleur de sortie 132 et piloté de manière similaire au coupleur de sortie 132 par une pluralité d'interrupteurs en dérivation du chemin de puissance pourrait par exemple être mis en oeuvre à la place du commutateur d'entrée 122.

Les interrupteurs étant positionnés en parallèle du chemin de puissance, ils ne sont plus parcourus par la puissance circulant le long de la voie passante. Ainsi, la limitation en puissance des interrupteurs n'est pas atteinte et la limite de tenue en puissance du dispositif dans son ensemble est repoussée. La puissance qu'il est alors possible de commuter n'est plus limitée par la tenue en puissance des commutateurs.

De plus, les interrupteurs n'étant plus sur le chemin de puissance, les pertes d'insertion inhérentes à l'utilisation d'un tel composant n'ont plus d'impact sur le rendement global du dispositif, ni sur le niveau de puissance délivrée en sortie.

De faibles pertes sont tout de même causées par les commutateurs parallèles 136 et 138 en raison de leur non idéalité, mais ces pertes demeurent sans commune mesure avec le cas où les commutateurs sont placés en série des chemins de puissance.

De nombreuses autres variantes du circuit de la figure 2 sont envisageables par l'homme du métier.

Le dispositif peut en particulier comporter plus de deux voies de puissance et de positions des moyens de commutation pour sélectionner la voie passante. Les moyens de commutation comportent, en sortie, par exemple une pluralité de coupleurs placés en cascade les uns des autres.

Dans le mode de réalisation décrit en détail, lorsque le chemin de puissance passe par la première voie, le signal est appliqué sur deux entrées du coupleur 132 fonctionnant en combineur. Il est donc avantageux de disposer en parallèle deux amplificateurs de manière à doubler la puissance générée par la voie de puissance correspondante. Mais ceci n'est pas obligatoire et d'autres modes de réalisation de la première voie sont envisageables.

Le dispositif selon l'invention trouvera des applications dans le cadre des systèmes de communication sans fil, plus particulièrement des systèmes de guerre électronique ou des systèmes radars militaires.

Un dispositif selon l'invention répond à la problématique de la conception d'amplificateurs de puissance reconfigurables en niveau de puissance et/ou en fréquence de travail en technologie MMIC, pour « Monolithic Microwave Integrated Circuit », (GaN ou GaAs), ou en technologie hybride.

En particulier, un coupleur du type coupleur de Lange présente une taille suffisamment réduite pour pouvoir être intégré dans un circuit, en particulier un circuit MMIC ou en technologie hybride.

## Revendications

1. Dispositif d'amplification de puissance reconfigurable (110) comportant, entre une entrée (112) et une sortie (114), une première voie de puissance (115) et une seconde voie de puissance (117), disposées en parallèle l'une de l'autre et indépendantes l'une de l'autre, et un moyen de commutation pour sélectionner dynamiquement l'une ou de l'autre des voies de puissance pour faire cheminer une puissance entre l'entrée et la sortie du dispositif, **caractérisé en ce que** le moyen de commutation comporte un coupleur de sortie (132) propre à fonctionner dans un mode coupleur ou dans un mode combineur, et un circuit de pilotage (136, 138) du coupleur de sortie de manière à le faire fonctionner soit en mode coupleur, pour que le chemin de puissance passe par la seconde voie de puissance, soit en mode combineur pour que le chemin de puissance passe par la première voie de puissance.

2. Dispositif selon la revendication 1, dans lequel le coupleur de sortie (132) comporte un port d'entrée directe (1) et un port d'entrée couplée (2) connectés à la première voie de puissance (115), un port de sortie couplée (4) connecté à la seconde voie de puissance (117), et un port de sortie directe (3) connecté à la sortie (114) du dispositif.

3. Dispositif selon la revendication 2, dans lequel les ports d'entrée directe (1) et couplée (2) du coupleur de sortie (132) sont connectés à la masse via des premiers interrupteurs (136) commandés, et le port de sortie couplée (4) du coupleur de sortie (132) est connecté à la masse, via à un second interrupteur (138), le mode coupleur étant obtenu en plaçant le second interrupteur dans une position ouverte et en plaçant les premiers interrupteurs dans une position fermée, tandis que le mode combineur est obtenu en plaçant le second interrupteur dans une position fermée et en plaçant les premiers interrupteurs dans une position ouverte.

4. Dispositif selon la revendication 3, dans lequel la première voie comporte une paire de premiers amplificateurs (116) en parallèle l'un de l'autre, la borne de sortie d'un amplificateur parmi les premiers amplificateurs étant connectée au pôle d'entrée directe (1) du coupleur de sortie (132), la borne de sortie de l'autre amplificateur parmi les premiers amplificateurs étant connectée au port d'entrée couplée (2) du coupleur de sortie (132).

5. Dispositif selon la revendication 4, dans lequel les signaux en sortie de chacun des premiers amplificateurs (116) de la première voie de puissance (115) sont en quadrature l'un de l'autre et, de préférence, possèdent la même amplitude.

6. Dispositif selon la revendication 5, dans lequel les signaux appliqués sur la borne d'entrée de chacun des premiers amplificateurs (116) de la première voie de puissance (115) sont délivrés respectivement par un port d'entrée couplée (2) et par un port de sortie directe (3) d'un coupleur d'entrée (130), dont un port d'entrée directe (1) est connectée à l'entrée du dispositif et dont un port de sortie couplée (4) est connecté à une charge (131), de manière à fonctionner en mode coupleur.

7. Dispositif selon l'une quelconque des revendications précédentes, dans lequel le moyen de commutation comporte, en outre, un commutateur d'entrée qui, dans une première position, connecte l'entrée (112) du dispositif à la première voie de puissance (115) et, dans une seconde position, l'entrée (112) à la seconde voie de puissance (117), le commutateur d'entrée et les moyens de pilotage du coupleur de sortie (132) étant commandés de manière synchronisée.

8. Dispositif selon l'une quelconque des revendications précédentes, dans lequel les propriétés d'amplification des première et seconde voies de puissance sont différentes en termes de gain et/ou de bande passante.

9. Dispositif selon la revendication 8, dans lequel la première voie de puissance (115) correspond à un fonctionnement du dispositif en bande passante étroite et forte puissance, tandis que la seconde voie de puissance (117) correspond à un fonctionnement du dispositif en bande passante large et moyenne puissance.

10. Circuit intégré en technologie hybride ou MMIC, comportant un dispositif d'amplification de puissance reconfigurable, **caractérisé en ce que** ledit dispositif (110) est conforme à l'une quelconque des revendications 1 à 9.
